# EUROPÄISCHE PATENTSCHRIFT

(11) **EP 3 237 913 B1**
(45) Veröffentlichungstag und Bekanntmachung des Hinweises auf die Patenterteilung: **13.05.2020**
(21) Anmeldenummer: 15834786.4
(22) Anmeldetag: 13.11.2015
(51) Int. Cl.: G01R 19/25, G05B 19/048, H02J 3/24

(54) **MESS- UND/ODER PRÜFVORRICHTUNG SOWIE VERFAHREN ZUR MESSUNG UND/ODER EINSCHÄTZUNG DER QUALITÄT UND/ODER STABILITÄT VON STROMNETZEN**
MEASURING AND/OR MONITORING DEVICE AND METHOD FOR MEASURING AND/OR EVALUATION OF THE QUALITY AND/OR STABILITY OF POWER GRIDS
DISPOSITIF DE MESURE ET/OU DE CONTRÔLE ET PROCÉDÉ POUR MESURER ET/OU ÉVALUER LA QUALITÉ ET/OU LA STABILITÉ DE RÉSEAUX ÉLECTRIQUES

(30) Priorität: 12.12.2014 DE 102014018475
(43) Veröffentlichungstag der Anmeldung: 01.11.2017
(73) Patentinhaber: A. Eberle GmbH & Co. KG, 90461 Nürnberg (DE)
(72) Erfinder: HUZMEZAN, Mihai, 91126 Schwabach (DE); HOFBECK, Martin, 90427 Nürnberg (DE); RÜSTER, Christian, 97907 Hasloch/Main (DE)
(74) Vertreter: Schuhmann, Albrecht
(86) Internationale Anmeldenummer: PCT/DE2015/000545
(87) Internationale Veröffentlichungsnummer: WO 2016/091239

(56) Entgegenhaltungen:
- EP-A1- 2 418 801
- WO-A1-2007/110004
- WO-A1-2011/032579
- WO-A1-2012/092203
- US-A1- 2005 136 972
- US-A1- 2007 007 968
- US-A1- 2013 069 627
- US-A1- 2014 225 603

## Beschreibung

Die vorliegende Erfindung betrifft eine Mess- und/oder Prüfvorrichtung sowie Verfahren zur Messung und/oder Einschätzung der Qualität und Stabilität von Stromnetzen, insbesondere um auf entsprechende bevorstehende oder sich ereignende Schwankungen und/oder Störungen in Versorgungsnetzen reagieren zu können.

Die Energiewende und der stetige Ausbau alternativer, regenerativer Energien haben die klassische zentralistisch-hierarchische Architektur unserer elektrischen Energieversorgungsnetze verändert. Es gibt heute bereits eine Vielzahl von Verteilnetze in denen die Mehrheit der erzeugten Energie aus "grünen", innerhalb der untersten Spannungsebene verteilten Energiequellen stammt. Kritisch ist hier zu sehen dass die Verlagerung der Erzeugung in die unteren und äußeren Verteilnetzgebiete schneller verläuft als der mess-, regel- und kommunikationstechnische Umbau dieser Netze.

An den Rändern dieser Netze - dort wo ein Großteil der neuen, verteilten Erzeugereinheiten angeschlossen sind, fehlen momentan an vielen Orten selbst einfachste Messgeräte zur Erfassung der Spannungsqualität, welche beispielsweise in den Normen (DIN) EN 50160, IEC 61000 festgelegt sind, sowie eine flächendeckende Kommunikationsinfrastruktur. Ein dezentral erzeugendes Netz benötigt allerdings ein Mindestmaß an ebenfalls dezentralen Mess- und Regeleinrichtungen um überhaupt stabil und effizient betrieben werden zu können, sowie um Störungen beispielsweise der Versorgungsqualität (Power Quality) in Endverbraucherhaushalten erkennen und beheben zu können.

Das Dokument US2007/0007968 offenbart eine Mess- und/oder Prüfvorrichtung zur Messung und/oder Einschätzung der Qualität und Stabilität von Stromnetzen wobei die Mess- und/oder Prüfvorrichtung als Vorrichtung mit Netzabgreifmittel und Netzteil ausgeführt ist, welche mit einer Einheit zur kontinuierlichen Abtastung und Weitergabe von Spannungswerten der Netzspannung über eine Schnittstelle und wenigstens einer AD-Wandlerschaltung zur Digitalisierung der Spannungswerte ausgerüstet ist und weiter über eine Mikrocontroller Einheit zur Aufbereitung und/oder Wandlung der Daten verfügt und diese an einer Schnittstelle des Mess- und/oder Prüfgerätes zur Verfügung gestellt sind.

Es gibt heute bereits eine Vielzahl konventioneller Messeinrichtungen zur Erfassung von Parametern der Spannungsqualität und der Netzstabilität, wie z.B.:
- Smart Meter
- High-end Power Quality Geräte (bis Klasse A)
- Verteilnetzautomatisierungsgeräte
- direkt bei Verbrauchern installierte Energiemonitoren
- Open Source Projekte: Open Power Quality Initiative.

Für eine detaillierte Erfassung des aktuellen Netzzustandes im Niederspannungsnetz müssten diese oder äquivalente Geräte jedoch idealerweise flächendeckend entlang der Ausläufer von Stromkabeln/-leitungen angebracht werden und Daten erfassen. Obwohl diese Art des Netzausbaus technisch sinnvoll wäre stehen in der Praxis bei Einsatz von Standardgeräten eine Reihe von Kosten- und Praktikabilitätsaspekten entgegen:
- Hoher Preis der Messgeräte
- Hoher Preis für Installation und/oder Betrieb eines dedizierten Telekommunikationsnetzwerkes für die Fernauslesung der Geräte
- Technische Komplexität des Einbaus (üblicherweise direkter Anschluß am Hausanschlußkasten/Sicherungskasten/Trafostation etc.)
- Technische Komplexität der Gerätebedienung (Inbetriebnahme und Betrieb)
- Technische Komplexität der Datenauswertung: manueller Zugriff auf individuelle Messdaten, komplizierte manuelle Auswertemethoden. Insgesamt nur durch ausgebildetes Fachpersonal sinnvoll umsetzbar.
- Großer Aufwand bei der Verarbeitung des großen Datenaufkommens bei Einsatz einer Vielzahl von Geräten: In der Regel nur isolierte Betrachtung einzelner Messdatenquellen möglich.
- Soll ein übergreifendes Bild des Netzzustandes in einem ganzen Netzgebiet erstellt werden sind eine Vielzahl von Datenquellen manuell auszuwerten und die Einzelergebnisse müssen mühsam zu einem Gesamtbild zusammengesetzt werden

Die Grundidee der vorliegenden Erfindung ist es deshalb, viele der oben angeführten Hindernisse oder Probleme durch entsprechende technische Innovationen zu umgehen.

Diese Aufgabe wird mit den Merkmalen des kennzeichnenden Teils des Anspruchs 1 gelöst. Fortbildungen und vorteilhafte Ausführungen der Erfindung sind in den weiteren Ansprüchen umfasst.

Erfindungsgemäß ist eine die Mess- und/oder Prüfvorrichtung die als Vorrichtung mit Netzabgreifmittel und Netzteil ausgeführt ist, welche mit einer Einheit mit wenigstens einer AD-Wandlerschaltung zur kontinuierlichen Abtastung, Digitalisierung und Weitergabe von wenigstens Spannungs- und/oder Frequenzwerten der Netzspannung über eine Schnittstelle ausgerüstet ist und weiter über eine Mikrocontroller Einheit zur Aufbereitung und/oder Wandlung der Daten verfügt und diese an einer Schnittstelle des Mess- und/oder Prüfgerätes zur Verfügung gestellt und/oder speicherbar sind wobei dies nach dem erfindungsgemäßen Verfahren:
Ermittlung von Netzmessdaten in einer, mit wenigstens einer Phase eines Stromnetzes verbundenen Mess- und/oder Prüfvorrichtung,
Weitergabe der Messdaten über eine erste, lokale Datenverbindung an eine interne Mikrocontroller Einheit und/oder ein IT-Gerät,
Verarbeiten und/oder Bearbeiten und/oder Bewertung der Daten in der Mikrocontroller Einheit und/oder dem IT Gerät und Versehen der Daten mit Zeitstempel und Ortskennzeichnung,
Weitergabe der Daten über eine zweite Datenverbindung an ein Rechenzentrum und/oder ein weiteres IT-Gerät und/oder ein Speichermedium,
Bewertung der Daten im Rechenzentrum und/oder beim Energieversorger und Einleiten von erforderlichen Anpassungen und/oder Eingriffen, erfolgt.

Die erfindungsgemäße Mess- und/oder Prüfvorrichtung und das Verfahren ist ein Weitbereichsmesssystem mit folgenden Komponenten:
∘ Ein preisoptimiertes Datenerfassungselement zur Abtastung des Netzzustandes des öffentlichen Stromnetzes:
   Die Datenerfassung erfolgt beispielsweise durch ein Standard-Steckernetzteil, einen Stecker-Zwischenschalter (z.B. Schaltnetzteil, ggf. mit USB-Ladekabel oder ein Zwischenstecker mit integrierter Steckdose) wie diese millionenfach zur Stromversorgung mobiler Endgeräte (Smartphones, DSL-Modems, Tablet-PCs, Laptop-PCs etc.) oder für Schalt- und/oder Messvorgänge eingesetzt werden. Dieses Steckernetzteil und/oder ein Stecker-Zwischengerät wird durch geeignete Bauteile um Funktionen zur Digitalisierung, ggf. Speicherung und Auswertung sowie Weitertransport von Netzmessdaten (momentane Spannung, Frequenz,...) erweitert ("intelligentes, messendes Steckernetzteil").
∘ Weitergabe der so erfassten Messdaten über eine erste lokale Datenverbindung: z.B. das standardmäßig vorhandene USB-Ladekabel, eine Netzwerkverbindung und/oder über drahtlose Schnittstellen an ein geeignetes
∘ IT-Gerät, wie beispielsweise einen Router, einen Computer, ein Mobilfunkgerät, ein Mobiltelefon oder ein Smart- Phone oder Smart- TV Gerät welches als preisoptimiertes Datenverarbeitungselement mit Zeitstempelungs- und Ortserfassungsfunktion agiert.
   Hier erfolgt eine mikroprozessor-gestützte Weiterverarbeitung der im Gerät und/oder Netzteil erfassten Messdaten in einer Applikation, z.B. eines Smartphones mit Hinzufügen eines Orts- und Zeitstempels (von GPS oder aus einer Internetressource). Die Weiterverarbeitung kann hier bereits in vollem Maße gemäß einer Analyse nach gängigen Power-Quality Standards erfolgen (EN 50160, IEC 61000,etc.).
   - Weitergabe der im Datenverarbeitungselement verarbeiteten Messdaten über eine zweite Datenverbindung mittels gängiger vorhandener Schnittstellen ins Weitbereichsnetz (WLAN, GSM, UMTS, LTE, Bluetooth, USB, LAN,...) an ein zentrales
   - Rechenzentrum und oder ein anderes IT Gerät. Hier werden serverbasierte Applikationen zur Messdatenspeicherung einer Vielzahl von Netzzustandsdaten vieler einzelner Messgeräte sowie zur automatischen, geräteübergreifenden statistisch-korrelativen Auswertung der Zustandsdaten des Netzes betrieben. ("Cloud-Applikation und Datenbank zur Big Data Analyse")
   - Weitergabe der zentral gespeicherten Daten bzw. der Analyse-Ergebnisse über eine weitere Datenverbindung ins Weitbereichsnetz. Übermittlung an verschiedenste Visualisierungsschnittstellen für Endbenutzer, insbesondere:
      ∘ Grafische Anzeige im Rechenzentrum,
      ∘ Bereitstellung für beliebige Endgeräte Dritter, z.B. mittels eines Internetportals
      ∘ Weitergabe an SCADA Systeme zur Integration in die IT Systeme von Stromnetzbetreibern
      ∘ Weitergabe über wenigstens ein geeignetes Netzwerk an die oben beschriebene Datenverarbeitungs-Applikation im Datenerfassungsgerät an der Messstelle, zur Visualisierung der geräteübergreifenden Ergebnisse.

Die technisch-wirtschaftlichen Vorteile die sich durch den Einsatz des erfindungsgemäßen Gesamtsystems ergeben sind sehr groß und wie folgt:
Ein extrem niedriger Anschaffungspreis des Gesamtsystems (kaum zusätzliche Hardware Kosten im Datenerfassungselement/Steckerelement oder Steckernetzteil, das Datenverarbeitungselement, wie etwa ein Smartphone, welches günstige Consumerelektronik ist).

Aus Sicht des Messstellenbetreibers verringern sich die Anschaffungskosten sogar noch drastischer, denn bei bereits üblich vorhandenem Smartphone fallen nur Kosten für das modifizierte Ladegerät und ggf. für den Kauf einer Software, wie einer App an.
Man erreicht einen niedrigen Preis für notwendige Bestandteile und/oder Elemente für das zur Beurteilung der Qualität des Stromnetzes erforderliche Telekommunikationsnetzwerk, da in der Regel für ein Smartphone mobile Datentarife oder DSL Tarife bereits vorhanden sind und nur in verschwindend geringem Maße durch das erfindungsgemäße System belastet werden. Auch kann das Smartphone oder ein IT Gerät in einem lokalen Netzwerk eingebunden sein, welches einen bestehenden Zugang zum Internet, meist mit Flatrate ermöglicht.
Wenige Netzzustands Daten aus der erfindungsgemäßen Mess- und/oder Prüfvorrichtung laufen parallel zum sowieso anfallenden Löwenanteil für die "normale" Telefonnutzung wie z.B. Multimediakonsum über die Datenverbindung z.B. ins Internet.

Weiter erreicht man durch diese bevorzugte Ausführung eine:
- Technisch triviale Inbetriebnahme durch einfaches Einstecken in die Steckdose
- Technisch einfache Bedienung und Betrieb des Messgeräts durch Mobiltelefon-Applikation die für technische Laien optimiert wurde
- Geringe technische Komplexität der Datenauswertung durch eine automatische geräteübergreifende Datenanalyse in einer Serverapplikation, wie etwa ausgeführt als Cloudapplikation oder klassisch vor Ort beim Messtellenbetreiber und/oder z.B. dem Energieversorger.
- Günstige automatische Analyse ersetzt hohen manuellen Aufwand
- Möglichkeit der Kosteneinsparung für Netzbetreiber durch Crowdsourcing, d.h. es müssen lediglich genug private Verbraucher dazu gebracht werden an der Netzüberwachung mittels des erfindungsgemäßen Systems teilzunehmen. Sind diese bereit, ihre sowieso in der Regel schon vorhandenen IT Internetdienste wie Breitbandverbindungen und/oder Mobiltelefone bzw. Mobilfunktarife einzubringen, so entfallen die entsprechenden Investitionen und laufenden Kosten für den Netzbetreiber.

Im Folgenden wird die Erfindung anhand von Zeichnungen beispielhaft näher beschrieben, dabei zeigen:
- Fig. 1: ein beispielhaftes, schematisches Schaltbild für eine Mess- und/oder Prüfvorrichtung
- Fig. 2: ein System mit Smartphone als IT Gerät beim Messstellenbetreiber
- Fig. 3: ein Schema für ein Verfahren zur Messung und/oder Einschätzung der Qualität und Stabilität von Stromversorgungsnetzen

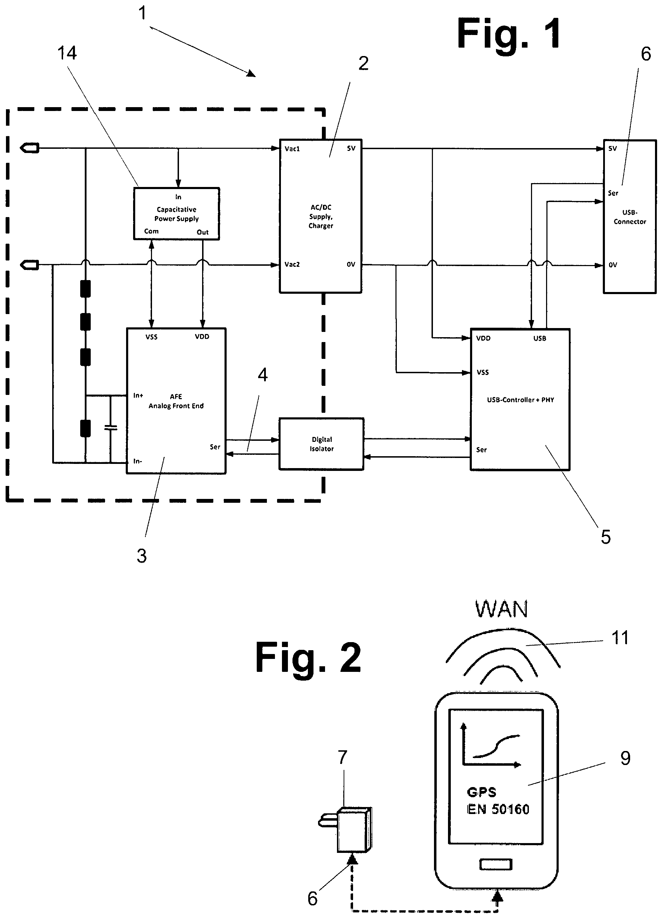

In Fig. 1 ist eine beispielhafte, schematische Schaltung einer erfindungsgemäßen Mess- und/oder Prüfvorrichtung zur Ermittlung von Daten, wie beispielsweise Spannung und/oder Frequenz, an einem Netzanschluss und/oder Versorgungsanschluss dargestellt.

Der Block "AC/DC Supply, Charger" 2 steht für die Gesamtheit aller Bauteile die in handelsüblichen Netzteilen und/oder Steckernetzteilen 7 und/oder Steckerzwischenschaltern enthalten sind. Hier in dieser beispielhaft gezeigten Ausführung wird die Wechselspannung des elektrischen Stromnetzes bedarfsgerecht über mehrere Stufen in eine 5V Gleichspannungsquelle nach USB Spezifikation umgewandelt.

Die Versorgungsspannung wird dem angeschlossenen Gerät (z.B. Smartphone 9) zum Zwecke des Batterieladens über die mit "5V" und "0V" beschrifteten Kontakte an einer hier beispielhaften USB Buchse als Schnittstelle 6 bereitgestellt.
Die restlichen Blöcke werden benötigt um die analoge Netzspannung abzutasten, zu digitalisieren und über eine USB Datenverbindung an das angeschlossene Datenverarbeitungsgerät (z.B. Smartphone) zu übermitteln.
Der Block "Capacitative Power Supply" 14 liefert die Betriebsspannung für das Analog Front End (AFE) 3.
Das Analog Front End (AFE) 3 tastet mittels geeigneter AD Wandlerschaltungen kontinuierlich die über resistive Spannungsteiler zugeführte Netzspannung ab und erzeugt Reihen digitalisierter Momentanwerte der Netzspannung.

Um die Berührungssicherheit zu gewährleisten werden die digitalen Momentanwerte anschließend über eine serielle Datenverbindung 4 und einen digitalen Isolator an einen Mikrocontroller Block 5 weitergeleitet der auch die Wandlung in das USB Datenübertragungsprotokoll übernimmt (Block "USB-Controller+PHY").
Alternativ ließe sich beispielsweise der Analog Front End (AFE) 3 anstelle durch den Block "Capacitative Power Supply" 14 auch aus der USB Spannung am Block "AC/DC Supply, Charger" 2 und einem ggf. erforderlichen DC / DC Wandler speisen.

In der Fig. 2 ist ein Smartphone 9 als beispielhaftes IT Gerät beim Messstellenbetreiber 10 gezeigt, das hier über eine USB Verbindung mit der Schnittstelle 6 des Stecker Netzteiles 7, in welchem die Komponenten der Mess- und/oder Prüfvorrichtung 1 untergebracht sind, verbunden ist. Über die hier gezeigte USB Verbindung wird bevorzugt das Smartphone oder ein anderes IT Gerät aufgeladen und/oder mit Strom versorgt und die Datenübertragung zwischen der im Ladegerät 7 untergebrachten Mess- und/oder Prüfvorrichtung mit dem IT Gerät oder besser gesagt mit der Anwendung (Software) auf dem IT Gerät, wie hier dem gezeigten Smartphone hergestellt.

Alternativ kann die, in dem Ladegerät und/oder Netzteil und/oder Steckernetzteil und/oder Stecker Zwischenschalter untergebrachte Mess- und/oder Prüfvorrichtung 1 auch mit oder zusätzlich mit einer abweichenden Schnittstelle wie LAN Netzwerkschnittstelle, wie Ethernetverbindung und/oder einer Funkschnittstelle, wie beispielsweise einer Bluetooth Schnittstelle und/oder WLAN Schnittstelle ausgerüstet sein. Die Daten können dabei Draht- gebunden und/oder drahtlos übertragen werden. Die Daten der Mess- und/oder Prüfvorrichtung an das IT Gerät, wie Smartphone bzw. an die entsprechende Software können dann mit einer z.B. WLAN und/oder Bluetooth Verbindung auch drahtlos übertragen werden.

Die erfindungsgemäße Mess- und/oder Prüfvorrichtung kann in nahezu alle Geräte mit Verbindung und/oder Zugriff auf einen Netzzugang integriert werden, wie eben in genannte Steckernetzteile, in Einfach- und/oder Mehrfachsteckdosen, in Stecker- Zwischensteckern, wie Schaltsteckdosen und/oder fernbedienbare Steckdosen oder auch zusätzlich in jedes Gerät mit einem Anschluss an das Stromnetz. Insbesondere bietet sich der Einsatz bzw. die Integration in alle Geräte an, welche ohnehin eine Verbindung zu einem IT Netzwerk erlauben und/oder welche eine Ladefunktion übernehmen und/oder welche eine Schaltfunktion am Stromnetz oder einer Steckdose erfüllen. Ein Gerät mit der integrierten Mess- und/oder Prüfvorrichtung kann in verschiedenen Ausführungen mit einer Vielzahl und/oder einer Auswahl von verschiedenen anderen Sensoren, bevorzugt von Sensoren zur Umgebungsbeobachtung und/oder Energieverbrauchssensoren ausgerüstet sein, welche gleichzeitig und/oder parallel Daten übertragen.

Für die Übermittlung aller Daten können verschiedene Übertragungswege zum Einsatz kommen welche auch parallel nutzbar sind. Bei der Integration der erfindungsgemäßen Mess- und/oder Prüfvorrichtung etwa in eine Zwischensteckdose, welche eine Schaltfunktion, wie das Ein- und Ausschalten und/oder Dimmen der Steckdose per Fernbedienung erlaubt, wird die Datenübertragung bevorzugt per Funk erfolgen. Die Zwischensteckdose kann dabei mit einer Applikation auf einer Fernbedienung oder eben auch von einem IT Gerät oder einem Smartphone bedient werden. Mit dem integrierten, erfindungsgemäßen System kann diese Zwischensteckdose weiter mit der Applikation gesteuert werden und zusätzlich überträgt die Mess- und/oder Prüfvorrichtung die ermittelten Daten zur Analyse und/oder Verarbeitung und/oder Weitergabe an ein IT Gerät, wie etwa ein Smartphone vom welchem aus diese an weitere Stellen übertragen werden um eine Kontrolle, Beobachtung und Störungserkennung im Stromnetz zu realisieren.

Zusätzlich können in dem Gerät mit der Mess- und/oder Prüfvorrichtung weitere Sensoren integriert sein, wie etwa für Lufttemperatur, Luftdruck, Luftfeuchte oder etwa Energie- Verbrauchsdaten eines angeschlossenen Gerätes, aber auch Beleuchtungsdaten, Bewegungserkennungen oder dergleichen. Alle diese Daten können parallel oder separat an ein und dasselbe und/oder verschiedene IT Geräte übertragen werden um dort weiter bearbeitet und/oder angezeigt und/oder weitergeleitet zu werden.

Die Erfassung der Messdaten dieser sekundären Sensoren kann unterschiedlichen, insbesondere zweierlei Zwecken, dienen. Zum einen können solche Daten die Interpretierbarkeit oder Aussagekraft der stromnetzbezogenen Messungen verbessern, z.B. weil typische Wetterdaten auch relevant für im Netz vorhandene Einspeisepunkte von erneuerbaren Energien wie beispielsweise Photovoltaik- und/oder Windkraftanlagen sind. Zum zweiten können die Daten zur weiteren Verwendung für die Integration als Sensoren und/oder Steuerungsmittel in Netzwerken, wie beispielsweise Überwachung oder Hausautomation genutzt werden.

Für Geräte die ohnehin einen IT Netzwerkanschluss besitzen, wie Multimedia Geräte, Übertrager, Router oder dergleichen in welche die erfindungsgemäße Mess- und/oder Prüfvorrichtung integriert ist, bietet sich der Anschluss an das Netzwerk über beispielsweise drahtgebundenes LAN, Ethernet, Lichtwellenübertragung oder ähnliches an, wobei auch hier Daten und Stromübertragungen parallel erfolgen können, wie beispielsweise mit Power over Ethernet Verbindungen.

Die Daten können dabei als Rohdaten, z.B. Spannungs- und/oder Frequenzwerte, die von der Messeinrichtung am Netzanschluss ermittelt worden sind übertragen werden oder von der Mikrocontrollereinheit in der Mess- und/oder Prüfvorrichtung vorher aufbereitet und anschließend übertragen werden, wodurch die Applikation auf dem Smartphone entlastet wird.
Die Anwendung in dem IT Gerät, hier dem Smartphone, welche laufend die in der Mess- und/oder Prüfvorrichtung gemessenen Netzzustandsdaten abfragt, versieht diese übertragenen Daten mit einem Zeitstempel und fügt den Daten eine Ortsangabe hinzu, welche mittels eines GPS Empfängers im Smartphone oder anhand von Internetdiensten, mit welchen das Smartphone und/oder das IT Gerät zusätzlich verbunden ist, zur Verfügung gestellt werden.

Beispiele für aus den Rohdaten abgeleitete und analysierte Größen und/oder Probleme sind die Messung der Netzfrequenz und Erkennung von Unter- oder Überfrequenz und/oder Ermittlung von Pegel und Phase der Netzspannung und damit Erkennung von Unter- und Überspannungen.
Weiter können Pegel und Phasen von Harmonischen und Interharmonischen der Netzfrequenz ermittelt werden, es kann der Flickerwert basierend auf Subharmonischen gebildet werden und Kurzzeitunterbrechungen können erkannt werden.
Neben den von der Mess- und/oder Prüfvorrichtung selbst gemessenen und weitergegebenen Daten in Form von Rohdaten und/oder aufbereiteten Daten mittels der Mikrocontrollereinheit ist in einer weiteren Variante ein abgesetzter Stromsensor in das System integrierbar und/oder mit dem IT Gerät und/oder der Software verbunden womit synchron auch die Strom-Messwerte in die Betrachtung und/oder Analyse mit einfließen können. Hierzu ist der Stromsensor bevorzugt über eine weitere Datenverbindung mit dem IT Gerät und/oder der Schnittstelle für die Software verbunden.

Die zeitgestempelten Daten werden weiter ausgewertet, z.B. nach Gesichtspunkten gängiger Normen zur Spannungsqualität und Netzstabilität (EN 50160 etc.). Ergebnisse können von der Software bzw. Applikation z.B. am Smartphone oder einem Tablet PC visualisiert werden sowie über Schnittstellen zu Weitbereichsnetzwerken weitergegeben werden.

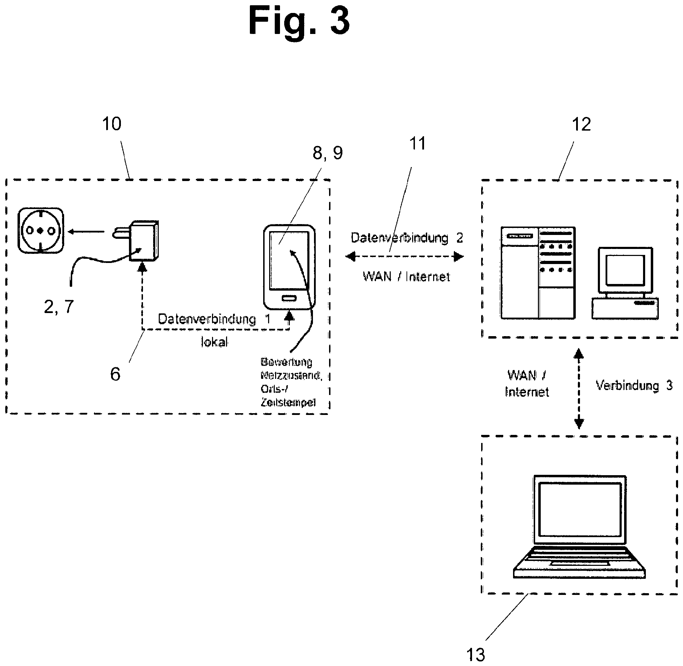

Wie in Fig. 3 gezeigt, werden die so bearbeiteten Daten von Spannungs- und/oder Frequenzverläufen und/oder des momentanen Wertes mit entsprechenden Angaben von Ort und Zeit versehen und werden über eine Datenleitung, bevorzugt über das Internet, an einen externen Dienstleister, wie einem Rechenzentrum 12 oder auch an den Netzbetreiber übertragen. Hier werden die Messdaten einer Vielzahl angeschlossener Messeinrichtungen gemeinsam erfasst, weiterverarbeitet, miteinander korreliert und analysiert. Dies ermöglicht beispielsweise die Bewertung ob eine bestimmte Netzstörung sich über einen ausgedehnten Netzbereich erstreckt oder nicht. Die Daten im Rechenzentrum 12 können dabei nochmals vorbehandelt werden und im Bedarfsfall mit Vorgabewerten verglichen werden um eine Aussage über evtl. Störungen und/oder der Notwendigkeit des Eingreifens in das Stromnetz, an einem definierten Ort, treffen zu können. Danach können diese Daten vom Netzbetreiber 13 abgerufen werden oder Abweichungen können direkt gemeldet werden.

Durch die relativ einfache oder anders gesagt, günstige Ausgestaltung eines am Stromnetz betriebenen Systems zur Messung von Werten, welche zur Beurteilung der momentanen Qualität des Stromnetzes beisteuern können, ist eine sehr feinmaschige Beobachtung des Stromnetzes und Erkennung von Veränderungen in einem solchen möglich. Es steht außer Frage, dass durch entsprechend viele Messstellen und die Auswertung der Messwerte von beispielsweise Spannung und/oder Frequenz eine sehr genaue Analyse der Stromnetzqualität ermöglicht wird und diese Informationen erst dazu beitragen um auf Veränderungen überhaupt zeitnah reagieren zu können. Gerade die dezentrale Einspeisung durch Photovoltaikanlagen, kleineren und mittleren Windkraftanlagen oder ähnlichen innerhalb der untersten Spannungsebene verteilten Energiequellen, stellt die Betreiber von Versorgungsnetzen vor Probleme da gerade in diesem Bereich bisher fast keine laufend aktualisierten Informationen über Spannungs- und/oder Frequenzverläufe verfügbar sind.

Das vorgestellte System einer Mess- und/oder Prüfvorrichtung sowie Verfahren zur Messung und/oder Einschätzung der Qualität und Stabilität von Stromversorgungsnetzen wird aufgrund seiner einfachen und kostengünstigen Umsetzung zu einem deutlichen Anstieg aktueller Informationen und/oder Daten von Stromnetzen liefern und dazu beitragen die Qualität und/oder den Betrieb von Stromversorgungsnetzten zu verbessern.

Nachdem bevorzugte Ausführungen der Erfindung in Bezug auf die beiliegenden Zeichnungen beschrieben wurden, ist festzuhalten, dass die Erfindung nicht auf diese genauen Ausführungen beschränkt ist und dass verschiedene Änderungen und Modifizierungen daran von einem Fachmann ausgeführt werden können, ohne dass vom Umfang der Erfindung, wie er in den beiliegenden Ansprüchen definiert ist abgewichen wird.

## Patentansprüche

1. Mess- und/oder Prüfvorrichtung zur Messung und/oder Einschätzung der Qualität und Stabilität von Stromnetzen
wobei die Mess- und/oder Prüfvorrichtung (1) als Vorrichtung mit Netzabgreifmittel und Netzteil (2) ausgeführt ist, welche mit einer Einheit (3) mit wenigstens einer AD-Wandlerschaltung zur kontinuierlichen Abtastung, Digitalisierung und Weitergabe über eine erste, lokale Datenverbindung von wenigstens Spannungs- und/oder Frequenzwerten der Netzspannung über eine Schnittstelle (4) ausgerüstet ist und weiter über eine Mikrocontroller Einheit (5) und/oder ein IT-Gerät zur Aufbereitung und/oder Wandlung der Daten verfügt und diese an einer Schnittstelle (6) des Mess- und/oder Prüfgerätes zur Verfügung gestellt und/oder speicherbar sind, wobei die Messdaten in der Mikrocontroller Einheit und/oder dem IT-Gerät mit Zeitstempel und Ortskennzeichnung versehen werden und über eine zweite Datenverbindung an ein Rechenzentrum und/oder ein weiteres IT-Gerät und/oder ein Speichermedium weitergegeben werden können.

2. Mess- und/oder Prüfvorrichtung nach Anspruch 1,
**dadurch gekennzeichnet,**
**dass** die Mess- und/oder Prüfvorrichtung als Ladegerät und/oder Kompaktnetzteil (7) ausgeführt ist und wenigstens über eine Schnittstelle (6) zur wenigstens Ausgabe und/oder Weitergabe der Rohdaten und/oder der aufbereiteten Daten zu einem IT Gerät (9) verfügt.

3. Mess- und/oder Prüfvorrichtung nach Anspruch 1,
**dadurch gekennzeichnet,**
**dass** die Mess- und/oder Prüfvorrichtung als Ladegerät und/oder Kompaktnetzteil ausgeführt ist und über wenigstens eine USB Schnittstelle zum Laden von Geräten, sowie zur Datenübermittlung an ein IT Gerät und/oder eine Speichereinheit verfügt.

4. Mess- und/oder Prüfvorrichtung nach Anspruch 1,
**dadurch gekennzeichnet,**
**dass** die Mess- und/oder Prüfvorrichtung über wenigstens eine Funk Schnittstelle zur Datenübermittlung an ein IT Gerät und/oder eine Speichereinheit verfügt.

5. Mess- und/oder Prüfvorrichtung nach Anspruch 1,
**dadurch gekennzeichnet,**
**dass** die Mess- und/oder Prüfvorrichtung über wenigstens eine Netzwerkschnittstelle zur Datenübermittlung an ein IT Gerät und/oder eine Speichereinheit verfügt.

6. Mess- und/oder Prüfvorrichtung nach Anspruch 1,
**dadurch gekennzeichnet,**
**dass** die Mess- und/oder Prüfvorrichtung mit einem Mittel zur Standorterfassung ausgerüstet und/oder mit einem IT Gerät mit Mittel zur Standorterfassung verbindbar ist.

7. Mess- und/oder Prüfvorrichtung nach Anspruch 1,
**dadurch gekennzeichnet,**
**dass** die Mess- und/oder Prüfvorrichtung mit einem Ortszeit Erfassungs- Mittel ausgerüstet und/oder mit einem IT Gerät mit Ortszeit Erfassungs- Mittel verbindbar ist.

8. Verfahren zur Messung und/oder Einschätzung der Qualität und Stabilität von Stromversorgungsnetzen, mit folgenden Schritte,
- Ermittlung von Netzmessdaten in einer, mit wenigstens einer Phase eines Stromnetzes verbundenen Mess- und/oder Prüfvorrichtung,
- Weitergabe der Messdaten über eine erste, lokale Datenverbindung an eine interne Mikrocontroller Einheit und/oder ein IT-Gerät,
- Verarbeiten und/oder Bearbeiten der Daten in der Mikrocontroller Einheit und/oder dem IT Gerät und Versehen der Daten mit Zeitstempel und OrtskennZeichnung,
- Weitergabe der Daten über eine zweite Datenverbindung (11) an ein Rechenzentrum (12) und/oder ein weiteres IT-Gerät und/oder ein Speichermedium,
- Bewertung der Daten im Rechenzentrum und/oder beim Energieversorger und Einleiten von erforderlichen Anpassungen und/oder Eingriffen.

9. Verfahren zur Messung und/oder Einschätzung der Qualität und Stabilität von Stromversorgungsnetzen nach Anspruch 8,
**dadurch gekennzeichnet,**
**dass** in der Mess- und/oder Prüfvorrichtung wenigstens die aktuelle Spannung und die Frequenz am Stromnetz mittels wenigstens einer AD-Wandlerschaltung ermittelt werden.

10. Verfahren zur Messung und/oder Einschätzung der Qualität und Stabilität von Stromversorgungsnetzen nach Anspruch 8,
**dadurch gekennzeichnet,**
**dass** die Messwerte in der Mikrocontroller Einheit in der Mess- und/oder Prüfvorrichtung in ein geeignetes Datenformat gewandelt werden und diese über eine USB Datenübertragungsverbindung und/oder eine Funk- Datenübertagungsverbindung an ein IT Gerät weitergeleitet werden.

11. Verfahren zur Messung und/oder Einschätzung der Qualität und Stabilität von Stromversorgungsnetzen nach Anspruch 8 und 10,
**dadurch gekennzeichnet,**
**dass** das erste IT Gerät ein Gerät mit spezifischer, programmierbarer Ablaufsteuerung zur Ver- und/oder Bearbeitung, Visualisierung und Weitergabe der Daten über eine zweite Datenleitung an ein Rechenzentrum und/oder ein weiteres IT Gerät ist.

12. Verfahren zur Messung und/oder Einschätzung der Qualität und Stabilität von Stromversorgungsnetzen nach Anspruch 8, 10 und 11
**dadurch gekennzeichnet,**
**dass** das erste IT Gerät ein Mobilfunkgerät und/oder ein Mobiltelefon oder ein Smartphone (9) ist, welches die Daten der Mikrocontrollereinheit empfängt und diese mittels einer spezifischen Anwendung visualisiert und/oder mit Zeitstempel und/oder Ortskennzeichnung versieht und über eine zweite Datenverbindung (11) an ein Rechenzentrum (12) und/oder ein IT Gerät eines Dienstleisters oder Betreibers weiterleitet.

## Claims

1. A measuring and/or testing device for measuring and/or evaluating the quality and stability of electricity grids, wherein the measuring and/or testing device (1) is designed as a device with a grid monitoring device and a power supply (2), which is equipped with a unit (3) with at least one AD converter circuit for continuously scanning, digitizing and transmitting at least voltage and/or frequency values of the grid voltage via a first, local data connection through an interface (4), and which additionally has a microcontroller unit (5) and/or an IT device for processing and/or converting the data, which are made available at an interface (6) of the measuring and/or testing device and/or can be stored, wherein the measurement data in the microcontroller unit and/or the IT device are tagged with time stamps and location markers and can be transmitted via a second data connection to a data centre and/or another IT device and/or a storage medium.

2. The measuring and/or testing device according to Claim 1,
**characterized in that**
the measuring and/or testing device is designed as a charging device and/or compact power supply (7) and has at least one interface (6) for at least outputting and/or transmitting the raw data and/or the processed data to an IT device (9).

3. The measuring and/or testing device according to Claim 1,
**characterized in that**
the measuring and/or testing device is designed as a charging device and/or compact power supply and has at least one USB interface for charging other devices, as well as for transmitting data to an IT device and/or a storage device.

4. The measuring and/or testing device according to Claim 1,
**characterized in that**
the measuring and/or testing device has at least one wireless interface for transmitting data to an IT device and/or a storage device.

5. The measuring and/or testing device according to Claim 1, **characterized in that** the measuring and/or testing device has at least one network interface for transmitting data to an IT device and/or a storage device.

6. The measuring and/or testing device according to Claim 1,
**characterized in that**
the measuring and/or testing device is equipped with a means for detecting location and/or can be connected with an IT device having means for detecting location.

7. The measuring and/or testing device according to Claim 1,
**characterized in that**
the measuring and/or testing device is equipped with a means for detecting local time and/or can be connected with an IT device having means for detecting local time.

8. A method for measuring and/or evaluating the quality and stability of electricity supply grids, with the following steps:
- Detecting grid measurement data in a measuring and/or testing device connected to at least one phase of an electricity grid,
- Transmitting the measurement data via a first, local data connection to an internal microcontroller unit and/or an IT device,
- Processing and/or editing the data in the microcontroller unit and/or the IT device and tagging the data with time stamps and location markers,
- Transferring the data via a second data connection (11) to a data centre (12) and/or another IT device and/or storage medium,
- Evaluating the data in the data centre and/or at the energy supplier and initiating necessary adjustments and/or interventions.

9. The method for measuring and/or evaluating the quality and stability of electricity supply grids according to Claim 8,
**characterized in that**
at least the current voltage and the frequency on the electricity grid are detected in the measuring and/or testing device by means of at least one AD converter circuit.

10. The method for measuring and/or evaluating the quality and stability of electricity supply grids according to Claim 8,
**characterized in that**
the measurement values are converted into a suitable data format in the microcontroller unit within the measuring and/or testing device and that said data are forwarded to an IT device via a USB data transfer connection and/or a wireless data transfer connection.

11. The method for measuring and/or evaluating the quality and stability of electricity supply grids according to Claims 8 and 10,
**characterized in that**
the first IT device is a device with a specific, programmable process control for processing and/or editing, visualizing and transferring the data via a second data line to a data centre and/or another IT device.

12. The method for measuring and/or evaluating the quality and stability of electricity supply grids according to Claims 8, 10 and 11,
**characterized in that**
the first IT device is a mobile radio unit and/or a mobile phone or smartphone (9), which receives the data of the microcontroller unit and visualizes the data by means of a specific application and/or tags the data with time stamps and/or location markers, and forwards the data to a data centre (12) and/or an IT device of a service provider or operator via a second data connection (11).

## Revendications

1. Dispositif de mesure et/ou de contrôle pour la mesure et/ou l'évaluation de la qualité et stabilité de réseaux électriques, dans lequel le dispositif de mesure et/ou de contrôle (1) est réalisé en tant que dispositif avec un moyen de mesure du réseau et un bloc d'alimentation (2), lequel est équipé d'une unité (3) avec au moins un circuit convertisseur A/N pour l'exploration en continu, la numérisation et le transfert, via une première liaison de données locale, au moins de valeurs de tension et/ou de fréquence de la tension du réseau via une interface (4), et qui dispose en outre d'une unité de microcontrôleur (5) et/ou d'un appareil informatique pour la préparation et/ou conversion des données, et celles-ci étant mises à disposition et/ou pouvant être enregistrées au niveau d'une interface (6) de l'appareil de mesure et/ou de contrôle, dans lequel les données de mesure dans l'unité de microcontrôleur et/ou l'appareil informatique sont dotées d'un horodatage et d'une désignation de lieu et peuvent être transférées via une deuxième liaison de données à un centre de calcul et/ou un autre appareil informatique et/ou un support de stockage.

2. Dispositif de mesure et/ou de contrôle selon la revendication 1,
**caractérisé en ce que**
le dispositif de mesure et/ou de contrôlé est réalisé en tant que chargeur et/ou bloc d'alimentation compact (7) et dispose au moins d'une interface (6) pour au moins la sortie et/ou le transfert des données brutes et/ou des données préparées à l'attention d'un appareil informatique (9).

3. Dispositif de mesure et/ou de contrôle selon la revendication 1,
**caractérisé en ce que**
le dispositif de mesure et/ou de contrôle est réalisé en tant que chargeur et/ou bloc d'alimentation compact et dispose au moins d'une interface USB pour la charge d'appareils, ainsi que pour la transmission de données à un appareil informatique et/ou une unité de stockage.

4. Dispositif de mesure et/ou de contrôle selon la revendication 1,
**caractérisé en ce que**
le dispositif de mesure et/ou de contrôle dispose au moins d'une interface radio pour la transmission de données à un appareil informatique et/ou une unité de stockage.

5. Dispositif de mesure et/ou de contrôle selon la revendication 1,
**caractérisé en ce que**
le dispositif de mesure et/ou de contrôle dispose au moins d'une interface réseau pour la transmission de données à un appareil informatique et/ou une unité de stockage.

6. Dispositif de mesure et/ou de contrôle selon la revendication 1,
**caractérisé en ce que**
le dispositif de mesure et/ou de contrôle est équipé d'un moyen pour la localisation et/ou peut être connecté à un appareil informatique avec un moyen pour la localisation.

7. Dispositif de mesure et/ou de contrôle selon la revendication 1,
**caractérisé en ce que**
le dispositif de mesure et/ou de contrôle est équipé d'un moyen de détection d'heure locale et/ou peut être connecté à un appareil informatique avec un moyen de détection d'heure locale.

8. Procédé pour la mesure et/ou l'évaluation de la qualité et stabilité de réseaux d'alimentation électrique, avec les étapes suivantes :
- déterminer des données de mesure du réseau dans un dispositif de mesure et/ou de contrôle raccordé à au moins une phase d'un réseau électrique,
- transférer les données de mesure via une première liaison de données locale à une unité de microcontrôleur interne et/ou un appareil informatique,
- traiter et/ou transformer les données dans l'unité de microcontrôleur et/ou l'appareil informatique et doter les données d'un horodatage et d'une désignation de lieu,
- transférer les données via une deuxième liaison de données (11) à un centre de calcul (12) et/ou un autre appareil informatique et/ou un support de stockage,
- évaluer les données dans le centre de calcul et/ou auprès du fournisseur d'énergie et initier des adaptations et/ou interventions nécessaires.

9. Procédé pour la mesure et/ou l'évaluation de la qualité et stabilité de réseaux d'alimentation électrique selon la revendication 8,
**caractérisé en ce que**,
dans le dispositif de mesure et/ou de contrôle, on détermine au moins la tension actuelle et la fréquence au niveau du réseau électrique au moyen au moins d'un circuit convertisseur A/N.

10. Procédé pour la mesure et/ou l'évaluation de la qualité et stabilité de réseaux d'alimentation électrique selon la revendication 8,
**caractérisé en ce que**
les valeurs de mesure dans l'unité de microcontrôleur sont converties dans le dispositif de mesure et/ou de contrôle à un format de données adéquat, et que celles-ci sont transférées via une liaison de transmission de données USB et/ou une liaison de transmission de données radio à un appareil informatique.

11. Procédé pour la mesure et/ou l'évaluation de la qualité et stabilité de réseaux d'alimentation électrique selon les revendications 8 et 10,
**caractérisé en ce que**
le premier appareil informatique est un appareil avec une commande séquentielle programmable spécifique pour le traitement et/ou la transformation, la visualisation, et le transfert des données via une deuxième liaison de données à un centre de calcul et/ou un autre appareil informatique.

12. Procédé pour la mesure et/ou l'évaluation de la qualité et stabilité de réseaux d'alimentation électrique selon les revendications 8, 10 et 11,
**caractérisé en ce que**
le premier appareil informatique est un appareil de radiocommunication mobile et/ou un téléphone portable ou un Smartphone (9), lequel réceptionne les données de l'unité de microcontrôleur et visualise celles-ci au moyen d'une application spécifique et/ou les dote d'un horodatage et/ou d'une désignation de lieu et les transfère via une deuxième liaison de données (11) à un centre de calcul (12) et/ou un appareil informatique d'un prestataire de services ou opérateur.
